# EUROPEAN PATENT SPECIFICATION

(11) **EP 3 060 032 B1**
(45) Date of publication and mention of the grant of the patent: **03.04.2019**
(21) Application number: 16156589.0
(22) Date of filing: 19.02.2016
(51) Int. Cl.: H05K 7/14, H04Q 1/02

(54) **POWER TERMINAL**
STROMANSCHLUSSKLEMME
BORNE DE PUISSANCE

(30) Priority: 20.02.2015 SE 1550196
(43) Date of publication of application: 24.08.2016
(73) Proprietor: Emilson, Per-Anders, 183 57 Täby (SE)
(72) Inventor: Emilson, Per-Anders, 183 57 Täby (SE)
(74) Representative: Bergenstråhle Group AB

(56) References cited:
- US-A- 5 712 779
- US-A1- 2012 108 084
- US-B1- 6 442 017

## Description

### TECHNICAL FIELD

The present disclosure relates to a power terminal. In particular the present disclosure relates to a power terminal for a telecommunications cabinet.

### BACKGROUND

In electrical cabinets containing devices for telecommunications there are typically provided racks and other electrical subassemblies. The devices located in a cabinet needs to be supplied with power. The power can be supplied in various ways. One way is to use a bar that distributes power to different sections of the cabinet. In the alternative a power distribution center can be provided inside the cabinet which supplies power to each power consuming electrical subassembly in the cabinet.

Further, the amount of power consumed in cabinets is constantly increasing resulting in that power supply cables connected to the electrical cabinets needs to have larger dimensions to allow for the increased power consumption.

A solution requiring a power distribution center is often less preferred in that it requires space inside the cabinet that can be better used for housing equipment. If on the other hand a power distribution bar as described in e.g. US2012/0108084 it is difficult to connect high current power supply cables to the bar, due to the space requirement which is associated, in particular, with the power supply.

Document US 6,442,017 B1 discloses a battery-power distribution unit which comprises two printed circuit assembly bus units that carry eight pairs of positive and negative screw terminal connections and their associated GMT- type fuses. Each A-side and B-side bus unit needs only one pair of heavy cables that feed it power inside a RETMA-rack cabinet.

There is a constant desire to improve the power supply to telecommunications equipment. Hence, there is a need for a cabinet for telecommunications equipment with improved power supply.

### SUMMARY

It is an object of the present invention to provide an improved power terminal.

This object and/or others are obtained by the power terminal as set out in the appended claims.

In accordance with one embodiment a power terminal to be mounted on an electrical cabinet housing electrical equipment, in particular telecommunications equipment, is provided. The power terminal comprises a frame enclosing a space, the power terminal further comprises mounting bar assemblies located in said space, where the mounting bar assemblies have a first type of terminals of a first dimension for receiving power supply cables and also have a second type of terminals of a second dimension for connecting power wires to the telecommunication equipment.

Hereby it is possible feed power to an electrical cabinet via power cables having big dimensions and at the same time enable use of the entire electrical cabinet for electrical assemblies, in particular telecommunications equipment. This is made possible since the power terminal can be mounted on top of or at the bottom of the electrical cabinet. Thus, the conversion from big dimension power supply cables to power supply wires with smaller dimensions used to supply the electrical equipment of the electrical cabinet takes place at the electrical cabinet without requiring any space inside the electrical cabinet.

The invention also extends to a cabinet for electrical assemblies, in particular telecommunications equipment, comprising a power terminal as described herein.

### BRIEF DESCRIPTION OF THE DRAWINGS

The present invention will now be described in more detail by way of non-limiting examples and with reference to the accompanying drawings, in which:
- Figs. 1a and 1b is a view of a power terminal in accordance with a first embodiment,
- Figs. 2a and 2b is a view of a power terminal in accordance with a second embodiment,
- Fig. 3 is a view of an electrical cabinet.

### DETAILED DESCRIPTION

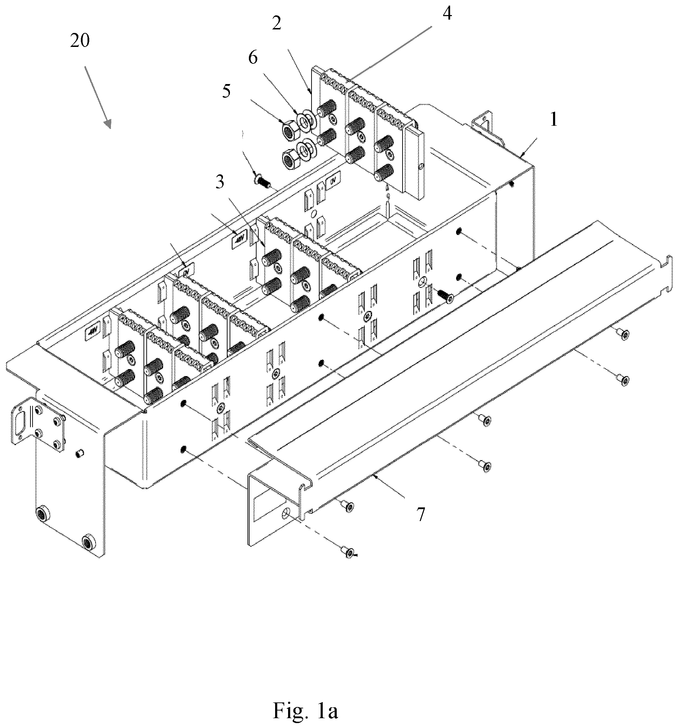

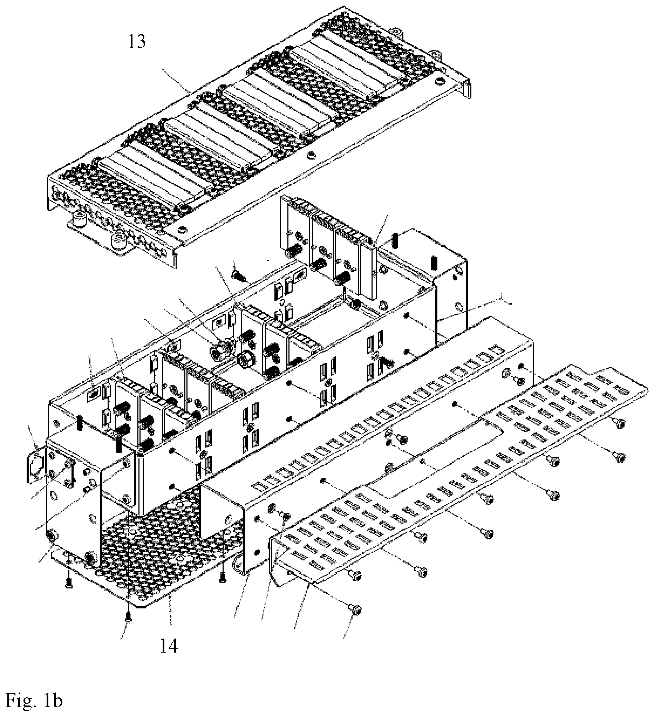

In Fig. 1a a view of a power terminal 20 for an electrical cabinet is depicted. The power terminal 20 of Fig. 1 is particularly useful for use in an electrical cabinet housing telecommunication equipments and racks of telecommunications equipments such as a radio base station or equipment for a core network.

The power terminal 20 of Fig. 1 comprises a frame 1. The frame 1 is shaped to fit on the top (or at the bottom) of an electrical cabinet. The frame is typically essentially rectangular with a space inside. The frame 1 can for example be made of aluminum or steel. The frame 1 can further comprise end sections having bent portions that can fit to secure the power terminal to an electrical cabinet. Inside the space of the frame 1 a number of mounting bars 2, 3 are provided. The mounting bars 2, 3 can in some embodiments be made of aluminum or FR-4 and be located with its end sections secured to the long sides of the frame 1. The mounting bars 2, 3 are used to hold power terminals 4 for power cables/wires. Typically there are two voltage supplies to an electrical cabinet, such as 0 V and - 48 V. One mounting bar 2 can then be associated with one voltage and another mounting bar 3 can be associated with another voltage. In the case with two voltages supplied to the electrical cabinet there are then at least two mounting bars, one for each voltage. In some embodiments there are four mounting bars, two for each voltage.
The mounting bars hence have power cable/wire terminals 4 mounted thereon. The terminals 4 are used to terminate supply power cables feeding power to the electrical cabinet from outside the electrical cabinet and also to terminate wires feeding power to equipment inside the electrical cabinet. In some embodiments the power is fed via a power supply bar arranged inside the electrical cabinet to the equipment inside the electrical cabinet. In some embodiments each wire terminals for receiving power cables/wires of different dimensions are mounted on the same mounting bar. For example in one embodiment relatively thick power supply cables such as 50 mm² or 90mm² are received from the outside and terminated on one side of a mounting bar in a wire terminal 4. In some embodiments the power supply cables can be in the range from 16 mm² - 107 mm². On the opposite side of the same mounting bar a power wire with smaller dimensions such as a 6mm² or a 25mm² power wire can be provided in another power terminal 4. The power wire with small dimensions is the used to feed power to the equipment inside the electrical cabinet. Further, an insulator can be provided between the mounting bar 2, 3 and the power terminals 4. The insulator can for example be made of a FR-4 printed circuit board material

The power cables/power wires can be connected to the wire terminals using any suitable means. For example nuts 5 and discs 6 can be used to attach the cables to the wire terminal terminals 4.

The power terminal can further be provided with shelves 7 secured to the frame 1.

In Fig. 1b a view similar to Fig. 1a is shown. In the embodiment of Fig. 1b perforated protector elements 13, 14 are provided. The perforated elements 13, 14 provide for IP20 protection so that the risk of reaching inside the power terminal is reduced or eliminated. The perforation are of small dimension such as about 10 mm in diameter or at least below 12 mm. This also reduces the risk that foreign objects can enter the power terminal. The perforated elements 13, 14 can be provided on top of and/or at the bottom of the power terminal and allow for a good air-circulation and at the same time protects the inside of the power terminal as set out above.

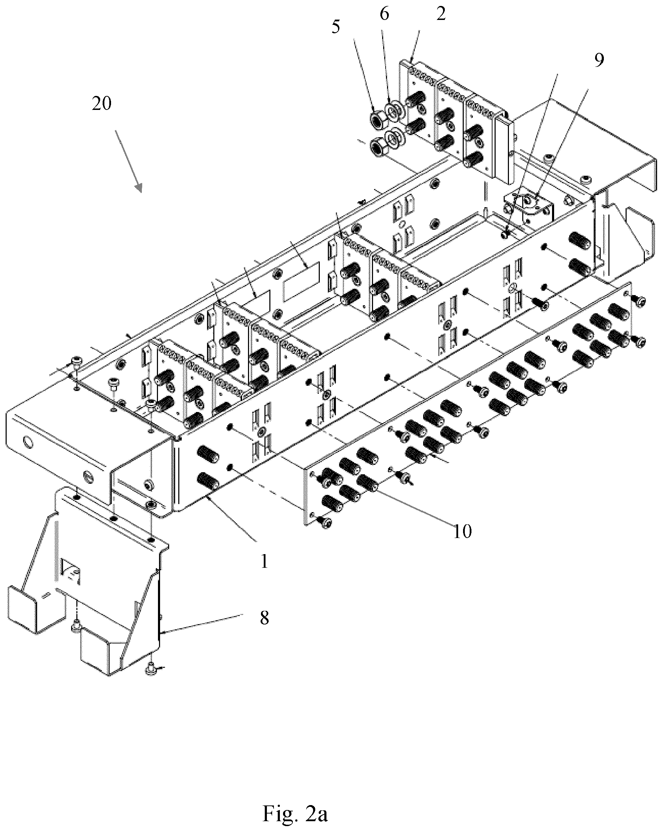

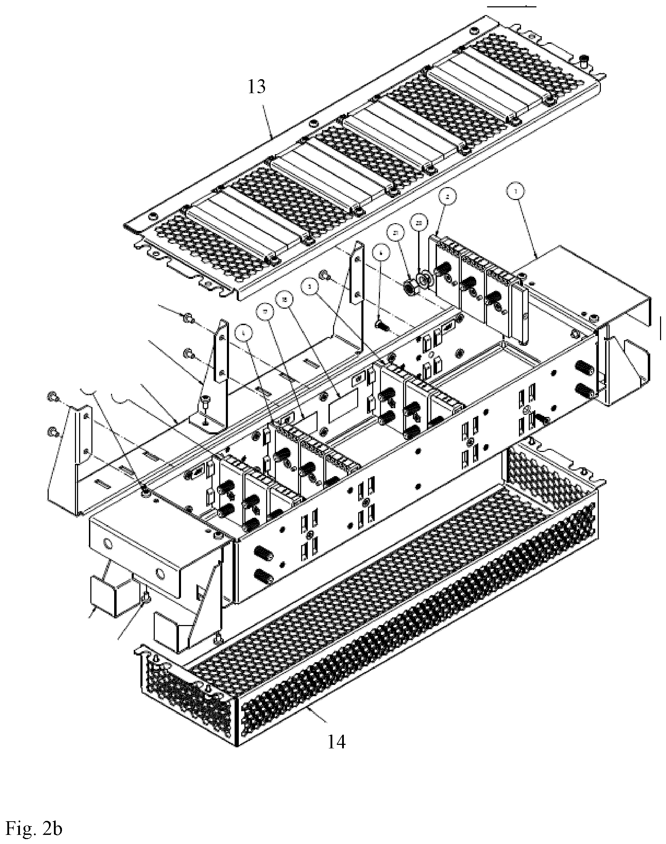

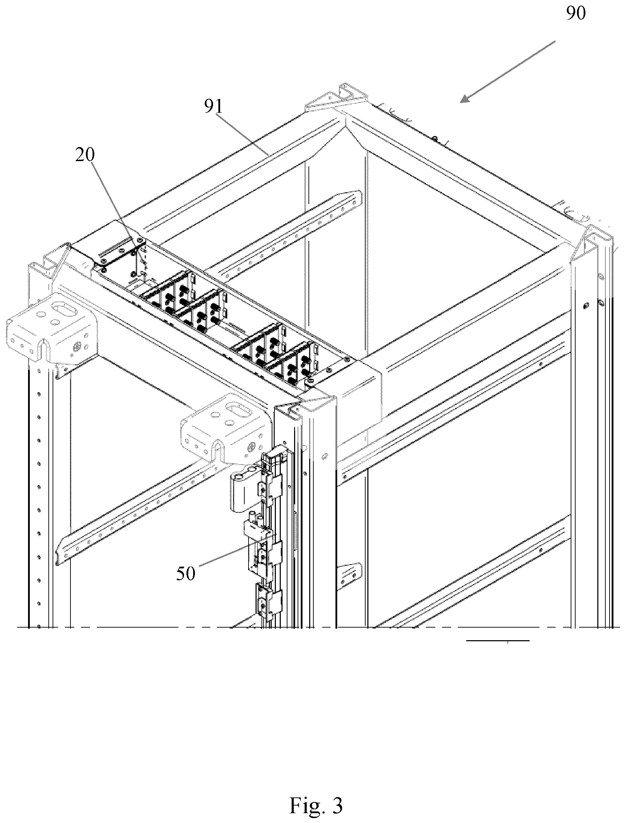

In Fig. 2a, a power terminal 20 in accordance with another embodiment is depicted. The power terminal in Fig. 2 is similar to the power terminal of Fig. 1 and is also suited to be mounted in the top or bottom section of an electrical cabinet. To secure the power terminal 20 of Fig. 2 to an electrical cabinet, the power terminal 20 comprises a fixing plate 8 that can be secured to an electrical cabinet using screws or similar securing means. Further, the power terminal can comprise a connector holder 9. The use of a connector holder is described in more detail below in conjunction with Fig. 3.

Also functional earth connectors 10 can be provided. The functional earth connectors can be used to connect earth to different electrical equipment of the electrical cabinet via earth wires from the electrical equipment to the functional earth connectors 10.

In Fig. 2b a view similar to Fig. 2a is shown. In the embodiment of Fig. 2b perforated protector elements 13, 14 are provided. The perforated elements 13, 14 provide for IP20 protection so that the risk of reaching inside the power terminal is reduced or eliminated. The perforation are of small dimension such as about 10 mm in diameter or at least below 12 mm. This also reduces the risk that foreign objects can enter the power terminal. The perforated elements 13, 14 can be provided on top of and/or at the bottom of the power terminal and allow for a good air-circulation and at the same time protects the inside of the power terminal as set out above.

In Fig. 3 an electrical cabinet 90, such as a cabinet housing telecommunications equipment, is depicted. The cabinet comprises a frame 91 typically made of metal. Along a side of the electrical cabinet 90 a power supply bar 50 is located. In one exemplary embodiment the power supply bar 50 is located along a corner of the electrical cabinet 90. In accordance with one embodiment the electrical cabinet 90 can comprise a power terminal 20 located at the top section (or bottom section) of the electrical cabinet. In particular the power terminal can be located above (or under) the space for electrical equipment inside the electrical cabinet 90. The power terminal can receive power supply cables from outside the electrical cabinet. Power supply wires can be provided from the power terminal 20 for feeding power to the power supply bar 50. Each power supply wire can feed as much as 150 A. Further a connector holder for connection to a conductive layer printed on the power supply bar can be located in the power terminal 20. The conductive layer on the power supply bar can feed an alarm signal from devices in the electrical cabinet such as circuit breaker or fuse alarm signals.

Using the power terminal as described herein it is possible feed high power to an electrical cabinet via power cables having big dimensions and at the same time enable use of the entire electrical cabinet for electrical assemblies, in particular telecommunications equipment. For example the power wires in the cabinet can provide 150 A. This is made possible since the power terminal can be mounted on top of or at the bottom of the electrical cabinet. Thus, the conversion from big dimension power supply cables to power supply wires with smaller dimensions used to supply the electrical equipment of the electrical cabinet takes place at the electrical cabinet without requiring any space inside the electrical cabinet.

## Claims

1. A power terminal (20) for mounting on an electrical cabinet (90), the power terminal comprising an essentially rectangular frame (1) enclosing a space, the power terminal further comprising mounting bars (2, 3) located inside said space, the end sections of each mounting bar (2, 3) being secured to the long sides of the frame (1), the mounting bars having mounted thereon a first type of terminals of a first dimension for receiving power supply cables and having mounted thereon a second type of terminals of a second dimension for connecting power wires to equipment in the electrical cabinet.

2. The power terminal according to claim 1, wherein the power terminal is adapted to be mounted at the top or bottom of the electrical cabinet.

3. The power terminal according to claim 1 or 2, wherein an insulator is provided between the mounting bar and said first and second type of terminals.

4. The power terminal according to any of claims 1 - 3, wherein a connector holder is provided in the power terminal.

5. The power terminal according to any of claims 1 - 4, wherein functional earth connectors are provided on the power terminal.

6. The power terminal according to any of claims 1 - 5, wherein the power terminal is provided with a perforated element (13, 14) covering the top and/or bottom of the power terminal.

7. An electrical cabinet (90) having a power terminal (20) mounted thereon, the power terminal comprising an essentially rectangular frame (1) enclosing a space, the power terminal further comprising mounting bars (2, 3) located inside said space, the end sections of each mounting bar (2, 3) being secured to the long sides of the frame (1), the mounting bars having mounted thereon a first type of terminals of a first dimension for receiving power supply cables and having mounted thereon a second type of terminals of a second dimension for connecting power wires to equipment in the electrical cabinet.

8. The electrical cabinet according to claim 7, wherein the power terminal is mounted at the top or bottom of the electrical cabinet.

9. The electrical cabinet according to claim 7 or 8, wherein the electrical cabinet comprises a power supply bar (50).

## Patentansprüche

1. Leistungsterminal (20) zur Montage an einem Elektroschrank (90), wobei das Leistungsterminal einen im Wesentlichen rechteckigen Rahmen (1) umfasst, der einen Freiraum umschließt, wobei das Leistungsterminal weiter Montagebalken (2, 3) umfasst, die innerhalb des Freiraums verortet sind, wobei die Endabschnitte von jedem Montagebalken (2, 3) an den langen Seiten des Rahmens (1) gesichert sind, wobei die Montagebalken einen ersten Typ von Anschlüssen von einer ersten Abmessung zum Empfangen von Leistungszufuhrkabeln an sich montiert haben und einen zweiten Typ von Anschlüssen von einer zweiten Abmessung zum Verbinden von elektrischen Leistungsdrähten mit Ausrüstung in dem Elektroschrank an sich montiert haben.

2. Leistungsterminal nach Anspruch 1, wobei das Leistungsterminal dafür angepasst ist, an der Oberseite oder der Unterseite des Elektroschranks montiert zu sein.

3. Leistungsterminal nach Anspruch 1 oder 2, wobei ein Isolator zwischen dem Montagebalken und dem ersten und zweiten Typ von Anschlüssen bereitgestellt ist.

4. Leistungsterminal nach einem der Ansprüche 1 - 3, wobei ein Verbindungshalter in dem Leistungsterminal bereitgestellt ist.

5. Leistungsterminal nach einem der Ansprüche 1 - 4, wobei funktionale Erdungsverbinder an dem Leistungsterminal bereitgestellt sind.

6. Leistungsterminal nach einem der Ansprüche 1 - 5, wobei das Leistungsterminal mit einem perforierten Element (13, 14) versehen ist, das die Oberseite und/oder Unterseite des Leistungsterminals bedeckt.

7. Elektroschrank (90), der ein Leistungsterminal (20) an sich montiert hat, wobei das Leistungsterminal einen im Wesentlichen rechteckigen Rahmen (1) umfasst, der einen Freiraum umschließt, wobei das Leistungsterminal weiter Montagebalken (2, 3) umfasst, die innerhalb des Freiraums verortet sind, wobei die Endabschnitte von jedem Montagebalken (2, 3) an den langen Seiten des Rahmens (1) gesichert sind, wobei die Montagebalken einen ersten Typ von Anschlüssen von einer ersten Abmessung zum Empfangen von Leistungszufuhrkabeln an sich montiert haben und einen zweiten Typ von Anschlüssen von einer zweiten Abmessung zum Verbinden von elektrischen Leistungsdrähten mit Ausrüstung in dem Elektroschrank an sich montiert haben.

8. Elektroschrank nach Anspruch 7, wobei das Leistungsterminal an der Oberseite oder Unterseite des Elektroschranks montiert ist.

9. Elektroschrank nach Anspruch 7 oder 8, wobei der Elektroschrank einen Leistungszufuhrbalken (50) umfasst.

## Revendications

1. Borne de puissance (20) à monter sur une armoire électrique (90), la borne de puissance comprenant un cadre essentiellement rectangulaire (1) renfermant un espace, la borne de puissance comprenant en outre des barres de montage (2, 3) situées à l'intérieur dudit espace, les sections d'extrémité de chaque barre de montage (2, 3) étant fixées aux côtés longs du cadre (1), les barres de montage ayant, monté sur celles-ci, un premier type de bornes d'une première dimension pour recevoir des câbles d'alimentation électrique et ayant, monté sur celles-ci, un deuxième type de bornes d'une deuxième dimension pour connecter des fils électriques à un équipement dans l'armoire électrique.

2. Borne de puissance selon la revendication 1, dans laquelle la borne de puissance est adaptée pour être montée au-dessus ou en dessous de l'armoire électrique.

3. Borne de puissance selon la revendication 1 ou 2, dans laquelle un isolant est prévu entre la barre de montage et lesdits premier et deuxième types de bornes.

4. Borne de puissance selon l'une quelconque des revendications 1-3, dans laquelle un support de connecteur est prévu dans la borne de puissance.

5. Borne de puissance selon l'une quelconque des revendications 1-4, dans laquelle des connecteurs de masse fonctionnels sont prévus sur la borne de puissance.

6. Borne de puissance selon la revendication 1-5, dans laquelle la borne de puissance est pourvue d'un élément perforé (13, 14) recouvrant le dessus et/ou dessous de la borne de puissance.

7. Armoire électrique (90) ayant une borne de puissance (20) montée sur celle-ci, la borne de puissance comprenant un cadre essentiellement rectangulaire (1) renfermant un espace, la borne de puissance comprenant en outre des barres de montage (2, 3) situées à l'intérieur dudit espace, les sections d'extrémité de chaque barre de montage (2, 3) étant fixées aux côtés longs du cadre (1), les barres de montage ayant, monté sur celles-ci, un premier type de bornes d'une première dimension pour recevoir des câbles d'alimentation électrique et ayant, monté sur celles-ci, un deuxième type de bornes d'une deuxième dimension pour connecter des fils électriques à un équipement dans l'armoire électrique.

8. Armoire électrique selon la revendication 7, dans laquelle la borne de puissance est montée au-dessus ou en dessous de l'armoire électrique.

9. Armoire électrique selon la revendication 7 ou 8, dans laquelle l'armoire électrique comprend une barre d'alimentation électrique (50).
